# EUROPEAN PATENT SPECIFICATION

(11) **EP 0 763 261 B1**
(45) Date of publication and mention of the grant of the patent: **02.08.2000**
(21) Application number: 95920590.7
(22) Date of filing: 25.05.1995
(51) Int. Cl.: H01L 39/24, H01P 7/10

(54) **FLUOROPOLYMER PROTECTANT LAYER FOR HIGH TEMPERATURE SUPERCONDUCTOR FILM AND PHOTO-DEFINITION THEREOF**
FLUORPLOYMER-SCHUTZSCHICHT FÜR HOCHTEMPERATURSUPRALEITENDE SCHICHT UND PHOTOSTRUKTUR DAVON
COUCHE PROTECTRICE EN FLUOROPOLYMERE POUR COUCHE MINCE SUPRACONDUCTRICE A HAUTE TEMPERATURE ET SA PHOTODEFINITION

(30) Priority: 03.06.1994 US 253797
(43) Date of publication of application: 19.03.1997
(73) Proprietor: E.I. DU PONT DE NEMOURS AND COMPANY, Wilmington Delaware 19898 (US)
(72) Inventor: LAUBACHER, Daniel, Bruce, Wilmington, DE 19807 (US); PANG, Philip, Shek, Wah, Media, PA 19063 (US)
(74) Representative: Jones, Alan John
(86) International application number: US9506427
(87) International publication number: WO9534096

(56) References cited:
- EP-A- 0 295 708
- EP-A- 0 341 501
- EP-A- 0 502 614
- WO-A-93/09575

## Description

### FIELD OF THE INVENTION

The present invention comprises methods and processes for patterning amorphous fluoropolymer Teflon®AF, and passivating high temperature superconductor films and devices with amorphous fluoropolymer Teflon®AF films. It also comprises improved devices using such amorphous fluoropolymer Teflon®AF films.

### BACKGROUND OF THE INVENTION

One of the deficiencies of some high temperature superconductors is their sensitivity to atmospheric moisture. Exposure of microwave and millimeter electronic devices containing superconducting materials to moisture usually results in performance degradation. Thus, means of passivation, or making the superconductor more inert to environmental factors is desired. Another problem for many superconducting devices is their large size, which is often dictated by power requirements. Thus, a means to increase the power of microwave and millimeter superconducting devices while maintaining a small size would provide numerous advantages in various applications. Copending Application U.S. Serial No. 07/788,063 filed November 5, 1991, discloses a microwave dielectric resonator comprising a) a dielectric element positioned between two discrete high temperature superconducting thin films, each said film deposited on a substrate, and b) an outer enclosure having means for holding the resonator components and means for magnetic dipole coupling. A means to increase the power of such devices is desirable.

U.S. Patent No. 5,159,347 discloses the use of amorphous fluoropolymer, Teflon®AF, in the construction of a micromagnetic circuit as an insulator between magnetic conductor strips and an electrical conductor. Use of such fluoropolymers in patterning films for microwave and millimeter devices has not been widespread. One of the desirable properties of a film of amorphous fluoropolymer is its essentially smooth, non-stick character. This is, however, viewed as a flaw if one is trying to cause a second material, i.e., a photoresist composition, to adhere to it. Imaging of the conventional photoresist over a fluoropolymer layer such as polymethyl methacrylate by deep UV followed by development leads to a photoresist mask over the fluoropolymer. This method suffers in two regards. First, an intermix layer may form due to the partial common solubility of the photoresist and the fluoropolymer. This leads to a lack of resolution during the subsequent etching of the fluoropolymer through the photoresist mask. Second, the patterned fluoropolymer is deficient to an amorphous fluoropolymer with respect to water resistance.

The present invention provides solutions to these various problems by providing a process for adhesion of and pattering of amorphous fluoropolymers such as Teflon®AF. This results in the further aspects of the present invention of a method of passivation for superconducting materials rendering them more inert to atmospheric moisture, and improved microwave and millimeter superconducting devices of increased power while retaining a small size.

EP-A-0 341 501 discloses a process for producing patterned fluoropolymer films which comprises a step of forming a continuous fluoropolymer film on a substrate assisted by an argon plasma and an argon beam. This document further discloses steps c) - g) as claimed in claim 1 but does not indicate exposing the surface of the fluoropolymer film to an oxygen plasma to promote adhesion of a second material such as a comercial photoresist composition.

### SUMMARY OF THE INVENTION

This invention provides a process for producing patterned amorphous fluoropolymer films which comprises the steps of:
a) forming a continuous amorphous fluoropolymer film on a substrate;
b) exposing the surface of the amorphous fluoropolymer film to an oxygen plasma to promote adhesion of a second material to the amorphous polymer film;
c) overcoating the adhesion promoted surface of the amorphous fluoropolymer film with a photoresist layer;
d) creating a latent image pattern in the photoresist layer by means of imagewise exposure to actinic radiation;
e) developing the imaged photoresist layer to create a patterned photoresist layer over the amorphous fluoropolymer film;
f) etching the amorphous fluoropolymer film through the patterned photoresist layer by reactive ion etching or ion beam etching; and
g) optionally, stripping the photoresist by organic solvents or by oxygen plasma etching.

### DESCRIPTION OF THE FIGURES

Figures la to 1d illustrate key steps of the process for patterning films of the present invention. A, B, C, and E each have the same meaning in Figures la through 1d. In Figure la, A is a substrate, B is a high temperature superconducting film, C is a layer of fluoropolymer, and D represents an oxygen plasma to which the surface C is being exposed.

Figure 1b depicts a photoresist layer E coating the fluoropolymer layer C.

Figure 1c depicts the development of a pattern in photoresist layer E by means of exposure to radiation and development labeled as F.

Figure 1d depicts the coated film after the fluoropolymer layer has been etched.

Figure 2a illustrates a known superconductor dielectric resonator of the sandwich type, HTS film-dielectric-HTS film, wherein HTS denotes high temperature superconducting.

Figure 2b illustrates a known sandwich type superconductor dielectric resonator which is tunable.

Figure 2c illustrates the improved sandwich type superconductor dielectric resonator of the present invention having a film of amorphous fluoropolymer (12) deposited on the superconducting film adjacent to the dielectric.

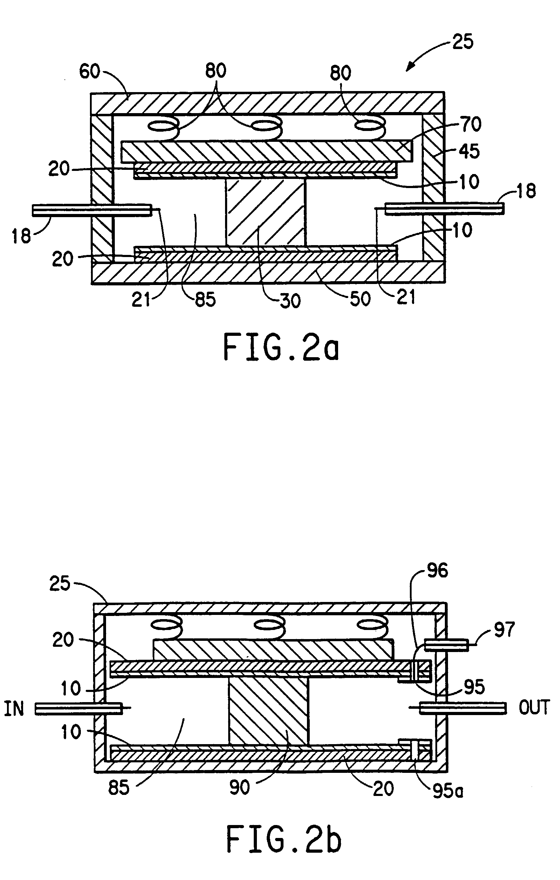

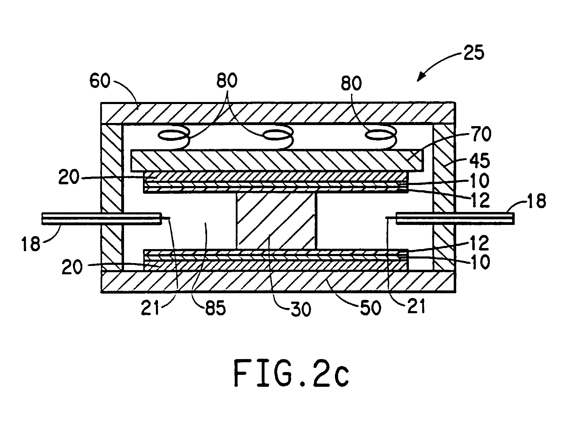

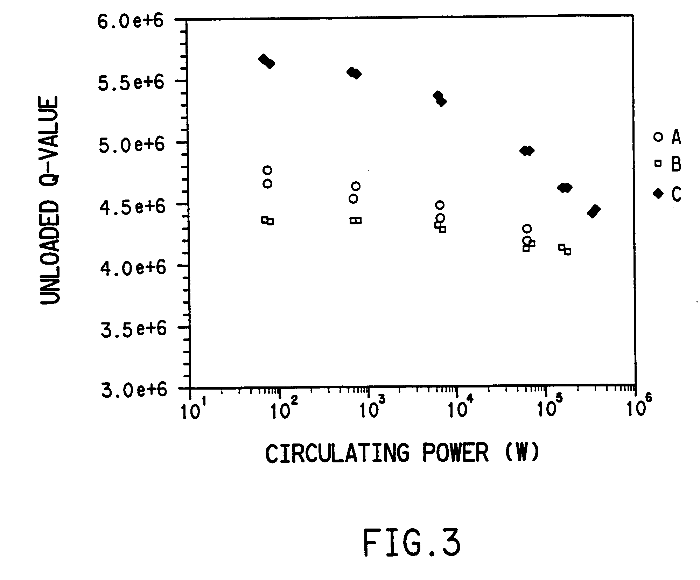

Figure 3 shows a graph of unloaded Q value versus circulating power for the resonators of Figures 2a and 2c. The white circles A represent the resonator of Figure 2a having no fluoropolymer coating on the superconducting film. The white boxes B represent a resonator as in Figure 2a but having a coating of polymethylmethacrylate on the superconducting film. The black diamonds C represent the resonator of the present invention of Figure 2c having a coating of Teflon®AF on the superconducting film. The improvement in performance gained by the resonator employing the present invention is demonstrated.

Figure 4 illustrates the improved radiofrequency device of the present invention. The specific elements will be detailed in the text hereinafter.

### DETAILED DESCRIPTION OF THE INVENTION

In known multilayer resist processes for patterning generally a photosensitive resist or photoresist is applied as a thin film to a substrate. The photoresist is then exposed in an image-wise fashion to light or radiation, for example through a mask. The mask contains clear and opaque features defining a pattern. The areas in the photoresist that are exposed are made either soluble or insoluble in a specific solvent termed a developer. Resists function by altering their solubility through radiation-induced chemical reactions. These reactions can either increase the solubility (positive tone) or decrease the solubility (negative tone) of the irradiated region. The terms positive and negative resists reflect this change in solubility. During development in the first case, the irradiated regions are dissolved by the developer leaving a positive image of the pattern in the resist and it is termed a positive resist. In the second case, the unirradiated regions are dissolved by the developer leaving a negative image of the pattern in the resist, and it is termed a negative resist. Following development the exposed substrate areas are etched through the patterned photoresist layer thereby replicating the pattern in the substrate. The photoresist layer is then optionally removed.

Known methods of providing an environmental protective layer over a film of high temperature superconductor comprise use of a layer of polymethyl methacrylate (PMMA) or polyimide. Neither material, though resistant to moisture, is as efficient as amorphous fluoropolymer film in this regard.

The present invention provides for use of an amorphous fluoropolymer film between the substrate and the photoresist layer. Such fluoropolymers provide a protective layer over the substrate and a method of passivation of devices incorporating the patterned substrate. Such amorphous fluoropolymers have not been used in known photoresist patterning processes because adhesion of the fluoropolymer to the substrate and the photoresist layer was a problem, and further because efficient techniques for etching such fluoropolymers without destroying the photoresist layer were not available.

By amorphous fluoropolymer film is meant a non-crystalline fluoropolymer or fluorocopolymer. Commercially available examples include a copolymer of 4,5-difluoro-2,2-bis(trifluoromethyl)1,3-dioxole and tetrafluoroethylene, (Teflon®AF) available from E. I. du Pont de Nemours and Company, Wilmington, Delaware. The thickness of the film employed is from 0.25 microns to 10 microns thick, preferably 0.5 to 3 microns.

The present invention provides a process for producing patterned amorphous fluoropolymer films comprising the steps of a) forming a continuous amorphous fluoropolymer film on a substrate; b) exposing the surface of the amorphous fluoropolymer film to an oxygen plasma to promote adhesion; c) overcoating the adhesion promoted surface of the amorphous fluoropolymer film with a photoresist layer; d) creating a latent image pattern in the photoresist layer by means of imagewise exposure to actinic radiation; e) developing the imaged photoresist layer to create a patterned photoresist layer over the amorphous fluoropolymer film; f) etching the amorphous fluoropolymer film through the patterned photoresist layer by reactive ion etching or ion beam etching; and g) optionally, stripping the photoresist by organic solvents or by oxygen plasma etching.

Substrates on which the patterning invention can be carried out include various types of substrates commonly used in electronic devices as well as various types of high temperature superconductors. The former include silicon, alumina (Al₂O₃), sapphire, gallium arsenide (GaAs) and indium phosphide (InP). Suitable superconductors are of many types and include YBaCuO, LaBaCuO, LaSrCuO, LaCaCuO, LaSrCaCuO, LaBaCaCuO, LaSrBaCuO, TlBaCaCuO, TlBaCuO, TlPbSrCaCuO, BiPbSrCaCuO, BiSrCaCuO, BiSrCuO, BiSrYCuO and others. Particularly preferred superconductors are YBaCuO (123), TlBaCaCuO (2212), TlBaCaCuO (2223), TlPbSrCaCuO (1212), TlPbSrCaCuO (1223), or BiSrCaCuO (2223). The high temperature superconductor may itself be on a support, for example, on lanthanum aluminate (LaAlO₃), yttrium stabilized zirconia, sapphire, quartz, magnesium oxide or strontium titanate.

Forming of the continuous amorphous fluoropolymer film on a substrate may be by methods known in the art for solution coating. These include knife coating, dip coating, roller coating, spray coating and spin coating. Preferred for use herein is spin coating.

It has been found that adhesion of the amorphous fluoropolymer can be promoted by subjecting the surface of the amorphous fluoropolymer film to an oxygen plasma, comprising greater than 10% oxygen plasma formed in a barrel or planar-type RF Plasma reactor or in a reactive ion etching reactor. This treatment apparently serves to increase adhesion of a second material to the amorphous fluoropolymer film by causing a modification of the surface, perhaps by introducing a degree of roughness into the treated surface. Such a treated amorphous fluoropolymer surface will readily hold any of a number of commercial photoresist compositions.

Photoresist requirements for microfabrication are similar, regardless of the exposure technology. The more important requirements include solubility, adhesion, etchant resistance, sensitivity and contrast (resolution). Since films are normally deposited on a substrate by spin-coating from solution, solubility in organic solvents is a necessary requirement. The resist must possess adequate adhesion to adhere to a variety of substrate materials and to withstand all processing steps. Poor adhesion leads to marked undercutting, loss of resolution and, in the worst case, complete destruction of the pattern. Pattern transfer to the underlying substrate has been conventionally accomplished using liquid etching techniques which require tenacious adhesion between resist and substrate in order to minimize undercutting and maintain edge acuity and feature size control. As geometrics are reduced, liquid etching is being replaced by dry-etching techniques which place less stringent adhesion requirements on the resist. It should be noted however, that there still has to be sufficient adhesion to withstand development, and this becomes increasingly difficult as feature sizes decrease. Etchant resistance refers to the ability of the resist to withstand the etching environment during the pattern transfer process. The need to pattern fine features in thick substrates has led to the development of anisotropic etching methods such as reactive-ion etching, plasma etching, ion milling, and sputter etching. While not requiring a premium in terms of adhesion, these techniques place other very stringent requirements on the resist. Most dry-etching techniques rely on plasma-induced gas reactions in an environment of high radiation flux and temperatures in excess of 80°C.

Sensitivity is conventionally defined as the input incident energy (measured in terms of energy or the number of photons or particles (fluence) per unit area) required to attain a certain degree of chemical response in the resist that results, after development, in the desired relief image. This represents an operational, lithographic definition of sensitivity. Note that sensitivity increases as the dose required to produce the lithographic image decreases. The sensitivity of a positive resist is the dose required to effect complete solubility of the exposed region under conditions where the unexposed region remains completely insoluble. In the case of a negative resist, sensitivity is defined as the dose at which a lithographically useful image is formed. Clearly, the sensitivity of a resist should be commensurate with machine design parameters to allow optimization throughput. The pattern resolution attainable with a given resist for a particular set of processing conditions is determined in large part by the resist contrast (γ). Contrast in the case of a negative resist is related to the rate of cross-linked network (gel) formation and, for a positive resist, to both the rate of degradation and the rate of change of solubility with molecular weight with the latter being markedly solvent dependent. High contrast is important since it minimizes the deleterious effects due to scattering of radiation in the resist film. All exposure techniques result in some energy being deposited outside the primary image area. High contrast resists which do not respond significantly to low levels of scattered radiation are desirable.

Photoresists useable in this inventive process are many. They may be positive or negative working. Positive resists are preferred. They may be single component or two-component systems. Both chain scission resists and solution inhibit resists are suitable for use herein. Planarizing layers, antireflection coatings and contrast enhancement materials may also be employed with the photoresists. They may be sensitive to a wide variety of actinic radiation, ranging from deep UV to UV to visible to infrared. Also the radiation can vary to x-ray radiation or electron or ion beams. Many suitable commercial varieties are available. Preferred examples include Shipley 1400 and 1800 series resists, and KTI890 and AZ1400 series resists available from Shipley Co. Inc., 2300 Washington Street, Newton, MA 02162. Overcoating the amorphous fluoropolymer film with the resist layer may be by various techniques after the amorphous fluoropolymer is treated to promote adhesion as described above. Suitable techniques for overcoating include knife coating, dip coating, roller coating, spray coating or spin coating. Spin coating is preferred.

Optional baking (drying) steps may follow the application of both the amorphous fluoropolymer layer and the application of the photoresist layer.

Amorphous fluoropolymers exhibit limited solubility in only a few select solvents. Due to the lack of a common solvent for the amorphous fluoropolymer and photoresists, no intermix layer is formed during the application of the photoresist to the amorphous fluoropolymer layer. This leads to a high degree of resolution in the photoimaging/development process.

Photoimaging and development steps for multi layer resist processes suitable for use in the present invention are discussed in "Microlithography: Process Technology for IC Fabrication," D. J. Elliott, McGraw Hill Book Company, 243-252, Bowden, M. K., "Materials for Microlithography", Thompson et al. Eds., ACS Symposium Series 266, pp. 39-107, American Chemical Society, Washington, DC (1984); and Reichmanis, E., et al. Chem. Rev. 89, 1273-1289 (1989) each of which is herein incorporated by reference.

Imaging and developing of the commercial photoresist composition employed in the present invention can be by recommended procedures by the photoresist manufacturer. The developer may be an organic solvent, dilute aqueous acid or dilute aqueous base depending upon the photoresist employed. After a post development drying step, the patterned photoresist layer functions as a mask for patterning of the amorphous fluoropolymer layer. Because of the water sensitivity of high temperature superconductor substrates and because the substrate underlies the amorphous fluoropolymer film, non aqueous patterning methods are employed when such substrates are used.

It has been found that reactive ion etching or ion beam etching can be employed to etch the amorphous fluoropolymer. Reactive ion etching using greater than 10% oxygen can be used to etch away the underlying amorphous fluoropolymer film at a rate much greater than the photoresist layer. Due to these differential etch rates between the photoresist and the amorphous fluoropolymer, the photoresist layer is not destroyed. The result of this process is a patterned, passivated area on the underlying substrate, preferably a high temperature superconductor film. The photoresist can optionally be removed by organic solvents or oxygen plasma etching.

The process of the present invention can be used to make materials useful as a) very thin film capacitors with extremely high breakdown potentials, and b) in the fabrication of multichip modules.

The use of amorphous fluoropolymer, patterned or not, in the construction of high temperature superconductor power carrying devices yields improvement in power carrying ability and resistance to moisture effects.

Devices of the prior art improvable by the patterning technology of the present invention include radiofrequency (RF) and microwave transmission line structures (microstrip, stripline or coplanar type), resonators, filters, delay lines, digital interconnects for integrated circuits, and MCM's (multi-chip modules).

The present invention further enables an improved microwave dielectric resonator comprising a) a dielectric element positioned between two discrete high temperature superconducting thin films, each said film deposited on a support, and b) an outer enclosure having means for magnetic dipole coupling, wherein the improvement comprises a layer of an amorphous fluoropolymer (Teflon®AF) positioned between the dielectric element and each high temperature superconducting film.

Figures 2a-2c show superconducting microwave resonators within holding devices. As shown in Figures 2a-c, superconducting microwave resonators with cavity **85** are provided in the form of supports **20** bearing superconducting film **10** positioned in contact with dielectric **30.** Support **20** is a single crystal that has a lattice matched to superconductor film **10.** Preferably, support **20** is formed of LaAlO₃, NdGaO₃, MgO and the like.

Generally, superconductor film **10** may be formed from any high T_{c} superconducting material that has a surface resistance (Rₛ) that is at least ten times less than that of copper at any specific operating temperature. T_{c} can be determined by the "eddy current method" using a LakeShore Superconductor Screening System, Model No. 7500. Surface resistance of superconducting film **10** can be measured by the method described in Wilker et al., "5-GHz High-Temperature-Superconductor Resonators with High Q and Low Power Dependence up to 90 K", *IEEE,* Trans. on Microwave Theory and Techniques, Vol. 39, No. 9, September 1991, pp. 1462-1467. Generally, superconductor film **10** is formed from materials such as YBaCuO (123), TlBaCaCuO (2212 or 2223), TlPbSrCaCuO (1212 or 1223), or the like.

Superconducting film **10** can be deposited onto support **20** by methods known in the art. See, for example, Holstein et al., "Preparation and Characterization of Tl₂Ba₂CaCu₂Og Films on 100 LaAlO₃", *IEEE,* Trans. Magn., Vol. 27, pp. 1568-1572, 1991 and Laubacher et al., "Processing and Yield of YBa₂Cu₃O₇₋ₓ Thin Films and Devices Produced with a BaF₂ Process", *IEEE,* Trans. Magn., Vol. 27, pp. 1418-1421, 1991. Generally, the thickness of film **10** is in the range of 0.2 to 1.0 micron, preferably 0.5 to 0.8 micron.

The microwave resonator is formed by positioning support **20** bearing superconducting film **10** on dielectric **30**. Supports **20** can be placed on the surface of dielectric **30**, or, alternatively, low loss adhesive materials may be employed. Polymethyl methacrylate optionally may be deposited onto the surface of superconducting film **10** to more firmly bond dielectric **30,** as well as to protect superconducting film **10.** Figure 2c shows the devices of the present invention with a film of amorphous fluoropolymer **12** between the superconducting film and the dielectric.

Dielectric **30** may be provided in a variety of shapes. Preferably, dielectric **30** is in the form of circular cylinders or polygons. Dielectric **30** may be formed of any dielectric material with a dielectric constant εᵣ>1. Such dielectric materials include, for example, sapphire, fused quartz, and the like. Generally, these dielectric materials have a loss factor (tan δ) of from 10⁻⁶ to 10⁻⁹ at cryogenic temperatures. The εᵣ and tan δ of the dielectric material can be measured by methods known in the art. See, for example, Sucher et al., "Handbook of Microwave Measurements", Polytechnic Press, Third Edition, 1963, Vol. III, Chapter 9, pp. 496-546.

The configuration of the microwave resonator, when in use, is maintained by holding device **25.** The holding device can be any embodiment that maintains the relative positions of the components of the resonator during thermal cycling associated with use of the resonator. Holding device **25** includes sidewalls **45,** bottom plate **50,** top lid **60,** pressure plate **70,** and load springs **80**. Load springs **80** are sufficiently strong to retain the configuration of the microwave resonator during thermal cycling. Load springs **80** preferably are formed of nonmagnetic material in order to prevent disturbing the radio frequency fields in the resonator to achieve the highest possible Q-values. Load springs **80** preferably are formed of Be-Cu alloys.

Parts **45, 50, 60** and **70** of holding device **25** are made of thermally and electrically conductive materials in order to reduce radio frequency loss as well as to enable efficient cooling of resonator. Parts **45, 50, 60** and **70** therefore may be formed of, for example, oxygen fired copper, aluminum, silver, preferably oxygen fired copper or aluminum.

The microwave resonator can be coupled to an electric circuit (not shown) by coaxial cable **18** that includes coupling loop **21** protruding into cavity **85** of the resonator. The orientation of coupling loop **21** and depth of insertion of coaxial cable **18** into cavity **85** can be readily adjusted to ensure coupling to the electronic circuit.

In order to make the resonator electrically tunable without lowering its Q-value, low loss ferroelectric or antiferroelectric material must be introduced into the resonator and a control E-field must be established in the ferroelectric or antiferroelectric material. Figure 2b shows one example of a tunable HTS-dielectric-HTS resonator. In this particular case, the dielectric is a ferroelectric or antiferroelectric rod **90,** which is sandwiched by a pair of HTS films **10** deposited on support **20.** The resonator operates at TE₀₁ₙ mode (n=1,2,3,...). The RF energy is coupled in and out by a pair of coaxial cables with a loop at the tip. The resonator is put in a holding device **25** with springs and spacer to hold it. In this particular case, the control circuit consists of a HTS-metal interface **95** with a via hole to the back side of the top support **20**, bonding wire **96**, control port **97,** another HTS-metal interface **95a** with a via hole on the bottom support to the case as a ground. When a control voltage is applied to the port **97**, an axial direction E-field is established in the rod **90** between the two HTS films **10**. The dielectric constant of the rod can be changed by varying the control voltage, which causes the the resonant frequency to change. Other control circuits and tuning mechanisms can be used in this type of resonator. The advantage of this configuration is that the tuning sensitivity is very high because the entire dielectric rod is made of ferroelectric or antiferroelectric material. Examples of suitable ferroelectric materials for rod **90** include LiNbO₃, LiTaO₃, or PbTiO₃. Examples of suitable antiferroelectric materials for rod **90** include SrTiO₃, LaAlO₃ or KMnF₃. But the disadvantage is that the Q-value of the resonator is limited by the loss factor of the ferroelectric or antiferroelectric material.

Figure 2c shows a HTS-dielectric-HTS resonator of the present invention. All elements are the same as those of Figure 2a but the resonator contains a layer of amorphous fluoropolymer **12** on the superconducting film **10**. The layer of amorphous fluoropolymer **12** is deposited on the superconducting film and patterned using the process of the present invention as previously described. The present invention also includes tunable resonators of the type shown in Figure 2b having an amorphous fluoropolymer layer on the superconducting film.

The high Tc superconductor-dielectric microwave resonators of Figures 2a-2c are capable of attaining high Q-values, due in part, to the ability of support **20** bearing film **10** to prevent axial radio frequency fields from extending beyond the London penetration depth of the superconducting film **10**. This is accomplished where supports **20** are substantially greater than the diameter of dielectric **30** so that radio frequency fields are confined within the cavity region **85** between supports **20.**

The use of a layer of amorphous fluoropolymer **12** on the superconducting film **10** has been found to decrease arcing and increase the power of the resonator by a factor of at least 2. The film **10** may contain small surface imperfections. If no amorphous fluoropolymer layer is present, air or other atmospheric gases can enter these imperfections. When electrical current circulates through the film, voltages can break down in these atmospheric gases causing electrical arcing which degrades the performance of the device. Use of a layer of amorphous fluoropolymer, preferably Teflon®AF, on the superconducting film surface fills in any imperfections and therefore decreases electrical arcing and increases the power of the resonator. Figure 3 depicts a comparison of the resonator of the present invention C with known resonator A of Figure 2a not having the amorphous fluoropolymer layer present and with known resonator B, like that of Figure 2a but having a layer of polymethyl methacrylate on the superconducting film. The resulting increase in the unloaded Q value of the resonator of the present invention is shown.

The high Q-value superconducting microwave resonators provided by the invention have a variety of potential applications. Typically, these resonators may be employed in applications such as filters, oscillators, as well as radio frequency energy storage devices. The microwave resonators of the invention also may be employed as frequency stable elements to reduce the phase noise for oscillators.

The present invention further comprises an improved radiofrequency device comprising a) a support having deposited thereon a signal layer comprising a high temperature superconducting thin film, b) at least one contact point comprising a conducting metal contact pad formed on the film, and c) at least one patterned dielectric layer, said layer coating the high temperature superconducting film and leaving exposed the contact pad, wherein the improvement comprises the use of an amorphous fluoropolymer (Teflon®AF) as a dielectric layer.

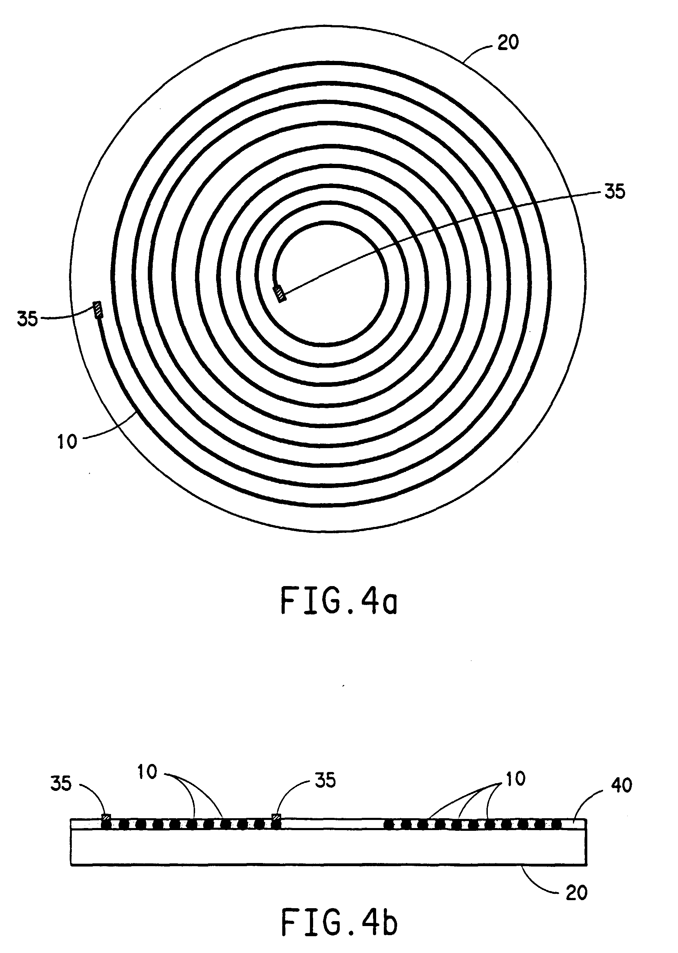

Figure 4 shows an improved radiofrequency device, a high power inductor device, using the present invention. This device typically carries power in the 2-30 megahertz range. Power carrying performance was improved with the amorphous fluoropolymer protectant film as was moisture (boiling water) sensitivity. The device is constructed (as in Example 3) on a support **20.** A coil pattern of high temperature superconductor material **10** is generated on the support as a signal layer. Patterns other than a coil are also suitable. The whole is covered by a layer **40** of amorphous fluoropolymer as a dielectric layer. The fluoropolymer is patterned and conducting electrical contacts **35** are formed on the superconducting signal layer.

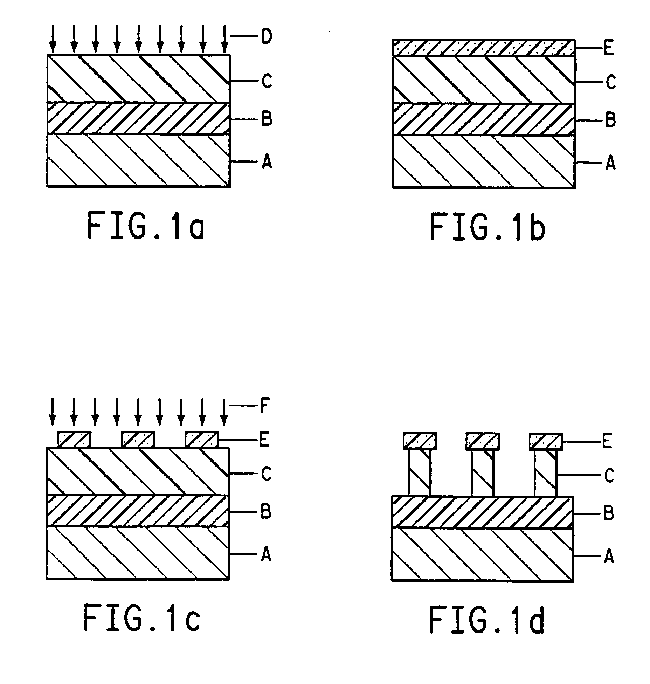

A thin film or high temperature superconductor is deposited on a suitable support using techniques well known in the art as previously referenced. Suitable supports and superconducting materials include those previously defined for the patterning process of the present invention. The amorphous fluoropolymer is deposited and patterned using the patterning process of the present invention previously described herein. Since reaction ion etching and ion beam etching can be used to etch both the positive photoresist layers and the amorphous polymer layers at different rates, the amorphous polymer can be etched before the photoresist layer is destroyed. Thus, a cross section as depicted in Figure 1d is obtained. Metal contact pads are then deposited on the superconducting film in the voids in the fluoropolymer layer previously created by the etching. The pads are deposited using known physical vapor deposition techniques such as sputtering or evaporation. Suitable metals for the contact pads include any conducting metal, preferably gold or silver. An increase of power level of about a factor of 2 compared to convention devices without the presence of an amorphous fluoropolymer is obtained in the RF devices of the present invention.

The improved radiofrequency device of the present invention is useful as a transformer or as an electrical interconnect or superprocessor in computer applications.

The present invention further comprises a method for passivation of superconducting devices comprising depositing on the superconducting material used in the device a layer of an amorphous fluoropolymer. This method is particularly applicable to high temperature superconducting thin films. Suitable superconductors include those previously defined for the patterning process of the present invention. As previously noted, exposure of the amorphous fluoropolymer to an oxygen plasma promotes adhesion of the amorphous fluoropolymer to the film. As detailed in Example 4, devices incorporating superconducting films coated with an amorphous fluoropolymer are passivated when exposed to moisture compared to conventional devices without the amorphous fluoropolymer. There is no degradation in electrical performance when the amorphous fluoropolymer is employed.

### EXAMPLES

Teflon®AF is a commercial product of E. I. du Pont de Nemours and Company, Wilmington, Delaware comprising a copolymer of 4,5-difluoro-2,2-bis(trifluoromethyl)1,3-dioxole and tetrafluoroethylene. Two grades are available, Teflon®AF 1600 and 2400. Both are available as white powders that can be dissolved in certain perfluorinated solvents for the production of highly uniform thin films and coatings through spin coating and other techniques. For the examples that follow, Teflon®AF 1600 dissolved (6% by weight) in Fluorinert FC-75 solvent was employed.

### EXAMPLE 1

A structure in the Teflon®AF was fabricated in the following manner.

The films of Teflon®AF were patterned using a standard photolithographic process using Reactive Ion Etching (RIE). A photoresist etch mask was used to define the pattern on the Teflon®AF films. The process utilized began with coating the amorphous fluoropolymer film (Teflon®AF) on the surface of the substrate. The Teflon®AF utilized was a 1:1 solution of 6% F11-0201-1600 with FC-75 solvent. A 1.7 µm Teflon®AF film was spin coated on the samples at 3000 rpm for 30 sec. The Teflon®AF was post baked to drive off its solvent at 250°C for 30 min. The post baked film of Teflon®AF was then exposed to a low power oxygen plasma for 2 min. in a MCS LF-5 plasma system. The plasma system was a conventional 13.56 MHz barrel etcher run at 250W power and 450 mTorr pressure. The Teflon®AF was then coated with Shipley 1400-17 positive photoresist to a thickness of 0.5 micron. The resist was cured in air at 90°C for 25 min. The 1400-17 was exposed to UV light in the range of 100 mJ per square centimeter. The 1400-17 was immersed in a 2:1 combination of Shipley MF312 developer to deionized water for 60 sec. The Teflon®AF was then etched down to the substrate by an oxygen RIE. The RIE system was a conventional 13.56 MHz, parallel plate reactor with the power applied to the bottom electrode (RIE mode). Samples were etched at a dc self-bias of 400 volts, a total gas flow rate of 15 sccm, substrate temperature of 30°C, and pressure of 20 mTorr. The chamber pressure was kept constant throughout the etching cycle by varying the pumping speed with an automatic throttle valve. This etching condition provided an anisotropic etch profile with extremely smooth sidewalls. The Teflon®AF films etched at a rate of 1 µm/min. The top resist masking the Teflon®AF film was removed with acetone.

### EXAMPLE 2

A structure in the Teflon®AF was fabricated in the following manner. The films of Teflon®AF were patterned using a standard photolithographic process using Reactive Ion Etching (RIE). A photoresist etch mask was used to define the pattern on the Teflon®AF films. The process utilized began with coating the amorphous fluoropolymer film (Teflon®AF) on the surface of the substrate. The Teflon®AF utilized was a 3:1 solution of 6% F11-0201-1600 with FC-75 solvent. A 2.5 µm Teflon®AF film was spin coated on the samples at 2000 rpm for 30 sec. The Teflon®AF was post baked to drive off its solvent at 250°C for 30 min. The post baked film of Teflon®AF was then exposed to a low power plasma for 2 min. in a MCS LF-5 plasma system. The plasma system was a conventional 13.56 MHz barrel etcher run at 250W power and 450 mTorr pressure. The Teflon®AF was then coated with Shipley 1400-17 positive photoresist to a thickness of 0.5 micron. The resist was cured in air at 90°C for 25 min. The 1400-17 was exposed to UV light in the range of 100 mJ per square centimeter. The 1400-17 was immersed in a 2:1 combination of Shipley MF312 developer to deionized water for 60 sec. The Teflon®AF was then etched down to the substrate by an oxygen RIE. The RIE system was a conventional 13.56 MHz, parallel plate reactor with the power applied to the bottom electrode (RIE mode). Samples were etched at a dc self-bias of 400 volts, a total gas flow rate of 15 sccm, substrate temperature of 30°C, and pressure of 20 mTorr. The chamber pressure was kept constant throughout the etching cycle by varying the pumping speed with an automatic throttle valve. This etching condition provided an anisotropic etch profile with extremely smooth sidewalls. The Teflon®AF films etched at a rate of 1 µm/min. The top resist masking the Teflon®AF film was removed with acetone.

### EXAMPLE 3

Epitaxial high temperature superconducting thin films of YBa₂Cu₃O₇ were deposited on two single crystal lanthanum aluminate substrates. The depositions were done using off axis magnetron sputtering with the substrate heated to between 600 and 800°C. The final film thicknesses were between 0.1 and 1 micron.

The films were patterned by a standard bi-level photolithography process using ion beam milling. A photoresist etch mask of a spiral coil with 1.5 mm wide lines and 100 µm gaps was used to define the spiral coil pattern on the HTS films. The bi-level photolith process utilized began with coating the HTS films with KTI 496 K molecular weight standard polymethyl methacrylate, PMMA, at 9% solids. The thickness was approximately 1.2 microns. The PMMA was cured at 170°C for 30 min. The PMMA was then coated with Shipley 1400-17 positive photoresist to a thickness of 0.5 micron. The resist was cured in air at 90°C for 25 min. The 1400-17 was exposed to UV light in the range of 100 mJ per square centimeter. The 1400-17 was immersed in a 2:1 combination of Shipley MF312 developer to deionized water for 60 sec. The photoresist was exposed to a low power oxygen plasma and descumed. The PMMA in open areas where the 1400-17 resist had been removed was exposed using a collimated deep UV source with 10 J per square centimeter in the 220-260 nm range. The exposed PMMA was developed using toluene for 4 min.

The now exposed HTS film was etched by argon ion beam milling. In order to etch the channels in the substrate, the now exposed areas of the substrate were etched by continuing the ion beam milling process with the substrate etched at the rate of 10 nm/min. Conducting metal bonds of gold were photolithographically defined utilizing exactly the process described above and were deposited on the HTS film using DC or RF sputtering. The substrates with the defined metal bumps were annealed at 510°C for 1 hour to ensure low metal to HTS contact resistance.

Five Au wirebond leads were attached to the metal contacts on the HTS films. The device was then cooled to liquid nitrogen temperatures and DC, RF, or a combination of electrical power with 15A peak current was transmitted through the spiral inductor. Failure rates of coils tested at this point to 15A power due to arcing was close to 100%. A 1.7 µm Teflon®AF film was spin coated on the samples at 3000 rpm for 30 sec. The Teflon®AF coated wafer and spiral structure was then post baked to drive off its solvent at 250°C for 30 min. The failure rate of coils tested with this coating was 0% at 15A power.

### EXAMPLE 4

Epitaxial high temperature superconducting thin films of YBa₂Cu₃O₇ were deposited on two single crystal lanthanum aluminate substrates. The depositions were done using off axis magnetron sputtering with the substrate heated to between 600 and 800°C. The final film thicknesses were between 0.1 and 1 micron.

The films were patterned by a standard bi-level photolithography process using ion beam milling. A photoresist etch mask of a spiral coil with 1.5 mm wide lines and 100 µm gaps was used to define the spiral coil pattern on the HTS films. The bi-level photolith process utilized began with coating the HTS films with KTI 496 K molecular weight standard polymethyl methacrylate, PMMA, at 9% solids. The thickness was approximately 1.2 microns. The PMMA was cured at 170°C for 30 min. The PMMA was then coated with Shipley 1400-17 positive photoresist to a thickness of 0.5 micron. The resist was cured in air at 90°C for 25 min. The 1400-17 was exposed to UV light in the range of 100 mJ per square centimeter. The 1400-17 was immersed in a 2:1 combination of Shipley MF312 developer to deionized water for 60 sec. The photoresist was exposed to a low power oxygen plasma and descumed. The PMMA in open areas where the 1400-17 resist had been removed was exposed using a collimated deep UV source with 10 J per square centimeter in the 220-260 nm range. The exposed PMMA was developed using toluene for 4 minutes.

The now exposed HTS film was etched by argon ion beam milling. In order to etch the channels in the substrate, the now exposed areas of the substrate were etched by continuing the ion beam milling process with the substrate etched at the rate of 10 nm/min. Conducting metal bonds of gold were photolithographically defined utilizing exactly the process described above and were deposited on the HTS film using DC or RF sputtering. The substrates with the defined metal bumps were annealed at 510°C for 1 hour to ensure low metal to HTS contact resistance.

Five Au wirebond leads were attached to the metal contacts on the HTS films. The device was then cooled to liquid nitrogen temperatures and DC, RF, or a combination of electrical power with 15A peak current was transmitted through the spiral inductor. A 1.7 µm Teflon®AF film was spin coated on the samples at 3000 rpm for 30 sec. The Teflon®AF coated wafer and spiral structure were then post baked to drive off the solvent at 250°C for 30 min.

Immersion of this structure in boiling H₂O for about 2 min. caused no reduction of the maximum power carrying capability. Immersion of this same structure in boiling H₂O with the Teflon®AF removed reduced the power carrying ability.

### EXAMPLE 5

Epitaxial high temperature superconducting thin films of YBa₂Cu₃O₇ were deposited on two single crystal lanthanum aluminate substrates. The depositions were done using off axis magnetron sputtering with the substrate heated to between 600 and 800°C. The final film thicknesses were between 0.1 and 1 micron.

The films were placed as endwalls of a sapphire loaded dielectric cavity as depicted in Figure 2a. When the films were run at high power, the unloaded quality factor (Qo) was relatively flat as a function of circulating power at 50 K temperature until it reached about 10⁴ W. At about 3 x 10⁴ W, the Qₒ was degraded by a factor of 2. See data points A in Figure 3. A 1.7 µm Teflon®AF film was spin coated on the samples at 3000 rpm for 30 sec. The Teflon®AF coated wafer and spiral structure were then post baked to drive off the solvent at 250°C for 30 min. The exact same cavity and films with the added Teflon®AF layer as depicted in Figure 2c were able to handle 3 x 10⁴W with no degradation of Qₒ as shown by data points C in Figure 3.

## Claims

1. A process for producing patterned amorphous fluoropolymer films which comprises the steps of:
a) forming a continuous amorphous fluoropolymer film on a substrate;
b) exposing the surface of the amorphous fluoropolymer film to an oxygen plasma to promote adhesion of a second material to the amorphous fluoropolymer film;
c) overcoating the adhesion promoted surface of the amorphous fluoropolymer film with a photoresist layer;
d) creating a latent image pattern in the photoresist layer by means of imagewise exposure to actinic radiation;
e) developing the imaged photoresist layer to create a patterned photoresist layer over the amorphous fluoropolymer film;
f) etching the amorphous fluoropolymer film through the patterned photoresist layer by reactive ion etching or ion beam etching; and
g) optionally, stripping the photoresist by organic solvents or by oxygen plasma etching.

2. The process of Claim 1 wherein the amorphous fluoropolymer is a copolymer of 4,5-difluoro-2,2-bis(trifluoromethyl)-1,3-dioxole and tetrafluoroethylene.

3. The process of Claim 1 wherein the substrate or superconducting film is selected from the group consisting of YbACuO (123), TlBaCaCuO (2212), TlBaCaCuO (2223), TlPbSrCaCuO (1212), TlPbSrCaCuO (1223) or BiSrCaCuO (2223) .

4. The process of Claim 1 wherein the substrate is on a support selected from the group consisting of lanthanum aluminate, yttrium stabilized zuconia, sapphire, quartz, magnesium oxide and strontium titanate.

## Patentansprüche

1. Verfahren zur Herstellung von strukturierten amorphen Fluorpolymerschichten, mit den folgenden Schritten:
a) Ausbilden einer zusammenhängenden amorphen Fluorpolymerschicht auf einem Substrat;
b) Einwirkenlassen eines Sauerstoffplasmas auf die Oberfläche der amorphen Fluorpolymerschicht, um die Haftung eines zweiten Materials auf der amorphen Fluorpolymerschicht zu verstärken;
c) Beschichten der haftverstärkten Oberfläche der amorphen Fluorpolymerschicht mit einer Photoresistschicht;
d) Erzeugen einer latenten Bildstruktur in der Photoresistschicht durch bildartiges Belichten mit aktinischer Strahlung;
e) Entwickeln der bebilderten Photoresistschicht, um über der amorphen Fluorpolymerschicht eine strukturierte Photoresistschicht zu erzeugen;
f) Ätzen der amorphen Fluorpolymerschicht durch die strukturierte Photoresistschicht hindurch mittels reaktivem Ionenätzen oder Ionenstrahlätzen; und
g) wahlfreies Ablösen des Photoresists durch organische Lösungsmittel oder durch Sauerstoffplasmaätzen.

2. Verfahren nach Anspruch 1, wobei das amorphe Fluorpolymer ein Copolymer aus 4,5-Difluor-2,2-bis(trifluormethyl)-1,3-dioxol und Tetrafluorethylen ist.

3. Verfahren nach Anspruch 1, wobei das Substrat oder die supraleitende Schicht aus der Gruppe ausgewählt ist, die aus YBaCuO (123), TlBaCaCuO (2212), TlBaCaCuO (2223), TlPbSrCaCuO (1212), TlPbSrCaCuO (1223) oder BiSrCaCuO (2223) besteht.

4. Verfahren nach Anspruch 1, wobei das Substrat auf einen Träger aufgebracht ist, ausgewählt aus der Gruppe, die aus Lanthanaluminat, mit Yttrium stabilisiertem Zirconiumdioxid, Saphir, Quarz, Magnesiumoxid und Strontiumtitanat besteht.

## Revendications

1. Procédé de production de films en polymère fluoré amorphe à motif qui comprend les étapes consistant à:
a) former un film en polymère fluoré amorphe continu sur un substrat;
b) exposer la surface du film en polymère fluoré amorphe à un plasma d'oxygène, afin de promouvoir l'adhésion d'un second matériau sur le film en polymère fluoré amorphe;
c) recouvrir la surface à promotion d'adhésion du film en polymère fluoré amorphe d'une couche de photorésine;
d) créer un motif d'image latente dans la couche de photorésine au moyen d'une exposition de formation d'image à un rayonnement actinique;
e) développer la couche de photorésine dotée d'une image, afin de créer une couche de photorésine à motif sur le film en polymère fluoré amorphe;
f) graver le film en polymère fluoré amorphe à travers la couche de photorésine à motif par gravure ionique réactive ou par gravure ionique; et
g) en option, ôter la photorésine par des solvants organiques ou par gravure au plasma d'oxygène.

2. Procédé selon la revendication 1, dans lequel le polymère fluoré amorphe est un copolymère composé de 4,5-difluoro-2,2-bis(trifluorométhyl)-1,3-dioxole et de tétrafluoroéthylène.

3. Procédé selon la revendication 1, dans lequel le substrat ou le film supraconducteur est sélectionné dans le groupe constitué du YbACuO (123), du TlBaCaCuO (2212), du TlBaCaCuO (2223), du TlPbSrCaCuO (1212), du TlPbSrCaCuO (1223) ou du BiSrCaCuO (2223).

4. Procédé selon la revendication 1, dans lequel le substrat est sur un support sélectionné dans le groupe constitué de l'aluminate de lanthane, de la zircone stabilisée à l'yttrium, du saphir, du quartz, de l'oxyde de magnésium et du titanate de strontium.
